# EUROPEAN PATENT SPECIFICATION

(11) **EP 3 605 261 B1**
(45) Date of publication and mention of the grant of the patent: **09.11.2022**
(21) Application number: 18770589.2
(22) Date of filing: 23.03.2018
(51) Int. Cl.: G05D 1/02

(54) **TRAJECTORY CONTROL SYSTEM FOR A MOBILE DEVICE AND CONTROL METHOD**
STEUERUNGSYSTEM FÜR EINE MOBILE VORRICHTUNG UND STEUERUNGSVERFAHREN
SYSTÈME DE CONTRÔLE DE TRAJECTOIRE POUR DISPOSITIF MOBILE ET PROCÉDÉ ASSOCIÉ

(30) Priority: 24.03.2017 CN 201710181094
(43) Date of publication of application: 05.02.2020
(73) Proprietor: Shanghai Slamtec Co., Ltd., Shanghai 201210 (CN)
(72) Inventor: BAI, Jing, Shanghai 201210 (CN); HE, Wenhao, Shanghai 201210 (CN); JI, Benniu, Shanghai 201210 (CN); LV, Junchao, Shanghai 201210 (CN); ZHANG, Di, Shanghai 201210 (CN); LI, Yuxiang, Shanghai 201210 (CN); HUANG, Jueshen, Shanghai 201210 (CN); CHEN, Shikai, Shanghai 201210 (CN)
(74) Representative: Gevers Patents
(86) International application number: PCT/CN2018/080272
(87) International publication number: WO 2018/171736

(56) References cited:
- EP-A1- 2 169 502
- CN-A- 102 183 959
- CN-A- 105 190 461
- CN-A- 105 259 898
- CN-A- 106 325 271
- CN-A- 106 325 271
- CN-A- 106 843 229
- CN-B- 102 866 706
- US-A1- 2016 062 357
- US-A1- 2016 165 795

## Description

### Technical Field

The present invention relates to a trajectory control system for a mobile device and an implementation method thereof.

### Background

At present, the existing setpoint cruise systems based on the preset trajectory are mainly implemented as follows:
First, laying track. Magnetic conductivity physical traction systems such as urban trams and some food-delivery robots are used for laying track to realize setpoint cruise according to a preset track. This scheme uses track technology and auxiliary sensors (infrared sensor, ultrasonic sensor and other sensors) to achieve obstacle avoidance behavior. Laying tracks has the following disadvantages: 1. additional deployment of tracks is required, which results in high cost, complicated operation and inflexible usage; 2. high operating noise and greatly change the environment.

Second, the visible light camera, infrared thermal imager and other detection instruments are used to patrol the line to achieve the setpoint cruise according to the preset trajectory. This scheme also requires the deployment of auxiliary equipment in the working environment. Similarly, the operation is complex, the cost is high and the operation is inflexible. In addition, there is no guarantee of environmental invariability and cleanliness.

Based on the deficiencies of the existing cruise system at setpoint according to the preset trajectory, the present invention provides a new virtual track design and a method for realizing the navigation system.

CN 102 866 706 B describes a cleaning robot using smart phone navigation. The cleaning robot comprises a cleaning robot module, a smartphone module including a smartphone camera, an image processing submodule, a camera calibration submodule, an EKF-SLAM submodule, a map maintenance and path planning submodule, a sensor submodule, and a sensor data acquisition submodule. The navigation and cleaning method has the following steps in sequence: 1) calibrate the parameters in the smartphone camera using a calibration template; 2) establish a Bluetooth communication connection; 3) start the EKF-SLAM submodule for precise positioning and create a 3D environment map; 4) establish an indoor environment obstacle coverage map; 5) automatically plan the cleaning route of the cleaning robot; 6) control the next movement of the walking wheels of the cleaning robot.

CN 106 325 271 A describes an intelligent mowing device. The intelligent mowing device comprises a mower main body and an auxiliary terminal which are separated. The mower main body comprises a communication module, a first GPS module and a first control module. The first GPS module and the first control module are connected to the communication module .The communication module transmits position information coming from the first GPS module to an auxiliary terminal The auxiliary terminal comprises a tracking positioning server, a man-machine interaction interface and a difference reference station. The man-machine interaction interface and the difference station are connected to the tracking positioning server. The correction information of the tracking positioning server can perform correction on position information of the mower machine coming from the communication module. The user can selectively input customized information into the man-machine interaction interface .The first control module controls behaviors of the mower main body according to corrected position information and customized information inputted by the user.

EP 2 169 502 A1 describes a method of controlling an autonomous vehicle. The method comprises controlling operations of the vehicle based at least in part on edge costs. An edge is a representation of a path the vehicle can traverse. Edge costs are determined by an estimation system and are based on at least one of an estimated travel time for an edge and a traverse-ability of the edge. The method further comprises sensing conditions of edges the vehicle is traversing and based on the sensed conditions, dynamically updating the edge costs.

### Summary

The technical problem to be solved by the present invention is to provide a trajectory control system for a mobile device and an implementation method for trajectory control in a trajectory control system for a mobile device, which does not need to deploy additional auxiliary equipment and is more convenient, flexible and fast to use. In addition, there is no impact on the environment, and it is more convenient to add and remove the virtual track, and the system is more intelligent.

The invention solves the above technical problems by means of a trajectory control system for a mobile device showing the technical characteristics of the first independent claim.

The invention also provides an implementation method for trajectory control in a trajectory control system for a mobile device showing the technical characteristics of the second independent claim.

### Brief Description of the Drawings

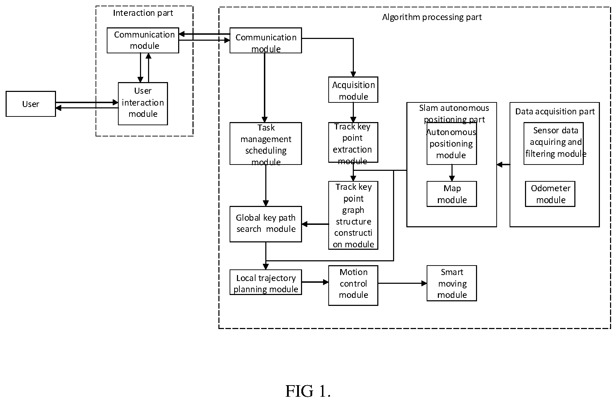

FIG. 1 is the schematic diagram of the present invention.

### Detailed Description of the Embodiments

In order to specifically explain the technical solution of the present invention, figure is used to represent the preferred embodiment of the invention as below.

As shown in FIG. 1, a trajectory control system for a mobile device of the present invention includes:
a communication module for providing relevant map information, virtual track information, positioning information, and task information transmission;
an interaction module in connection with the communication module and configured to set a virtual track with arbitrary shape and length through graphical editing environment, and to support segmental modification, deletion of tracks and other functions;
an acquisition module in connection with the communication module and configured to get the virtual track information from the interaction module via the communication module, and to store relevant data;
an orbital key point extraction module in connection with the acquisition module, wherein the acquisition module is configured to send the virtual track information to the orbital key point extraction module, and wherein the orbital key point extraction module is configured to extract key point information of the virtual track from the virtual track information according to limiting conditions such as a curve slope and piecewise fitting to find key points where the first order derivative is 0;
a sensor data acquisition and filtering module configured to collect data of a sensor on the mobile device and to remove noise on the data via a filtering algorithm;
an odometer module configured to obtain mileage data of the mobile device;
wherein the sensor data acquisition and filtering module and the odometer module form together a data acquisition part;
a map module configured to use a simultaneous localization and mapping, SLAM, related algorithm to build an environment map, wherein the environment map can be used for global path planning;
an autonomous positioning module in connection with the map module and configured to construct a storage module by combining the environment map, wherein a relevant matching algorithm is used to obtain the current position information and posture information of the mobile device, such that the mobile device knows its position and posture in the environment map in real time;
wherein the map module and the autonomous positioning module form together a SLAM autonomous positioning part, and wherein the SLAM autonomous positioning part is in connection with the data acquisition part to receive sensor data and mileage data;
a graph structure construction module of the orbital key point in connection with the extraction module and with the SLAM autonomous positioning part, and configured to use key point information received from the orbital key point extraction module and map information received from the sensor data acquisition and filtering module via the SLAM autonomous positioning part to combine the accessibility between key points, to construct vertex and edge information of the graph structure;
a task scheduling management module in connection with the communication module and configured to to manage navigation tasks issued by a user, including setting task sequence, task distribution, task execution logic, invoking path planning service and other parts;
a global key point path search module in connection with the task scheduling management module and the graph structure construction module of orbital key point and configured to search the optimal path along the virtual track from starting point to end point according to a task issued by the task management scheduling module and information of the autonomous positioning module, combined with a heuristic search algorithm, by using track graph structure of orbital key point received from the graph structure module of orbital key point, and configured to guide the mobile device to complete a cruise task;
a local trajectory planning module in connection with the global key path search module and the SLAM autonomous positioning part, and configured to generate a smooth collision-free control decision by using observation data fused by multi-sensor, current virtual track node information and autonomous positioning information, and by combining with the current speed information such that the mobile device can complete the cruise task without collision.
a motion control module in connection with the local trajectory planning module and configured to generate motion control decisions by using collision free control decisions generated by the local trajectory planning module.
an intelligent movement module in connection with the motion control module and configured to receive the instruction of the motion control module to control collision-free movement of the mobile device.

The communication module and the interaction module constitute an interaction part.

The acquisition module, the straight line extraction module, the segmentation search trees building module, the observation data fusion module, the virtual map building storage module, the task scheduling management module, the map building storage module, the autonomous positioning module, the global path planning module, the local path planning module, the motion control module, and the intelligent movement module constitute an algorithm processing part.

An implementation method for trajectory control in a trajectory control system for a mobile device provided by the invention includes the following steps:
Step 1: setting, adding, deleting and editing a virtual track in an interaction module and sending virtual track information to an algorithm processing part via a client communication module.
Step 2: receiving the virtual track information sent by the interaction module via the client communication module at a communication module of the algorithm processing part.
Step 3: receiving the virtual track information of the virtual track at an acquisition module via the communication module of the algorithm processing part, and extracting by the acquisition module, key point information of the virtual track from the virtual track information according to limiting conditions such as a curve slope and piecewise fitting to find key points where the first order derivative is 0.
Step 4: receiving the key points information at a graph structure construction module, combining map information received from a map module, key points information of the virtual track, and accessibility between key points to construct vertex and edge information of a graph structure;
Step 5: receiving at a search module a navigation task via the communication module of the algorithm processing part and positioning information from an autonomous positioning module and searching according to a search algorithm an optimal key points path along the virtual track from starting point to end point by using the graph structure of the key points along the virtual track.
Step 6: receiving at a trajectory planning module the key points path generated in step 5, fusion observation information and autonomous positioning information of the mobile device, and motion speed and model information of the mobile device, and combining the key points path, the fusion observation information and autonomous positioning information and the motion speed and model information to generate a control decision.
Step 7: receiving at a motion control module the control decision of step 6, smoothening the speed according to the control decision , and issuing control instructions to the mobile device to control the movement of the mobile device.

The detailed embodiment above further specifically explains the technical problems, the technical solution and beneficial effects of the present invention. It should be understood that the above is only a specific embodiment of the present invention, which should not be used to limit the invention. Any modification, equivalent replacement and improvement made within the principles of the invention shall be included in the protection scope of the invention.

## Claims

1. A trajectory control system for a mobile device, comprising:
- a communication module for providing relevant map information, virtual track information, positioning information, and task information transmission;
- an interaction module in connection with the communication module and configured to set a virtual track with arbitrary shape and length through graphical editing environment and to support segmental modification, deletion of tracks and other functions;
- an acquisition module in connection with the communication module and configured to get the virtual track information from the interaction module via the communication module and to store relevant data,
- an orbital key point extraction module in connection with the acquisition module, wherein the acquisition module is configured to send the virtual track information to the orbital key point extraction module, and wherein the orbital key point extraction module is configured to extract key point information of the virtual track from the virtual track information according to limiting conditions such as a curve slope and piecewise fitting to find key points where the first order derivative is 0;
- a sensor data acquisition and filtering module configured to collect data of a sensor on the mobile device and to remove noise on the data via a filtering algorithm ;
- an odometer module configured to obtain mileage data of the mobile device; wherein the sensor data acquisition and filtering module and the odometer module form together a data acquisition part;
- a map module configured to use a simultaneous localization and mapping, SLAM, related algorithm to build an environment map, wherein the environment map can be used for global path planning;
- an autonomous positioning module in connection with the map module and configured to construct a storage module by combining the environment map, wherein a relevant matching algorithm is used to obtain the current position information and posture information of the mobile device such that the mobile device knows its position and posture in the environment map in real time;
wherein the map module and the autonomous positioning module form together a SLAM autonomous positioning part, and wherein the SLAM autonomous positioning part is in connection with the data acquisition part to receive sensor data and mileage data;
- a graph structure construction module of orbital key point in connection with the extraction module and with the SLAM autonomous positioning part, and configured to use key point information received from the orbital key point extraction module and map information received from the sensor data acquisition and filtering module via the SLAM autonomous positioning part, to combine accessibility between key points, to construct vertex and edge information of the graph structure ;
- a task scheduling management module in connection with the communication module and configured to manage navigation tasks issued by a user, including setting task sequence, task distribution, task execution logic, invoking path planning service and other parts;
- a global key point path search module in connection with the task scheduling management module and the graph structure construction module of orbital key point and configured to : search the optimal path along the virtual track from starting point to end point according to a task issued by the task management scheduling module and information of the autonomous positioning module, combined with a heuristic search algorithm, by using track graph structure of orbital key point received from the graph structure module of orbital key point, and configured to guide the mobile device to complete a cruise task;
- a local trajectory planning module in connection with the global key path search module and the SLAM autonomous positioning part, and configured to generate a smooth collision-free control decision by using observation data fused by multi-sensor, current virtual track node information and autonomous positioning information, and by combining with the current speed information such that the mobile device can complete the cruise task without collision;
- a motion control module in connection with the local trajectory planning module and configured to generate motion control decisions by using collision free control decisions generated by the local trajectory planning module; and
- an intelligent movement module in connection with the motion control module and configured to receive the instruction of the motion control module to control collision-free movement of the mobile device.

2. An implementation method for trajectory control in a trajectory control system for a mobile device, comprising the following steps:
step 1: setting, adding, deleting and editing a virtual track in an interaction module and sending virtual track information to an algorithm processing part via a client communication module;
step 2: receiving the virtual track information sent by the interaction module via the client communication module at a communication module of the algorithm processing part;
step 3: receiving the virtual track information of the virtual track at an acquisition module via the communication module of the algorithm processing part, and extracting by the acquisition module, key point information of the virtual track from the virtual track information according to limiting conditions such as a curve slope and piecewise fitting to find key points where the first order derivative is 0;
step 4: receiving the key points information at a graph structure construction module, combining map information received from a map module, key points information of the virtual track, and accessibility between key points to construct vertex and edge information of a graph structure;
step 5: receiving at a search module a navigation task via the communication module of the algorithm processing part and positioning information from an autonomous positioning module, and searching according to a search algorithm an key points path along the virtual track from starting point to end point by using the graph structure of the key points along the virtual track;
step 6: receiving at a trajectory planning module the key points path generated in step 5, fusion observation information and autonomous positioning information of the mobile device, and motion speed and model information of the mobile device, and combining the key points path, the fusion observation information and autonomous positioning information and the motion speed and model information to generate a control decision; and
step 7: receiving at a motion control module the control decision of step 6, smoothening the speed according to the control decision, and issuing control instructions to the mobile device to control the movement of the mobile device.

## Patentansprüche

1. Trajektoriesteuersystem für eine mobile Vorrichtung, umfassend:
- ein Kommunikationsmodul zum Bereitstellen von Übertragung von relevanten Karteninformationen, Informationen zur virtuellen Spur, Positionierungsinformationen und Aufgabeninformationen;
- ein Interaktionsmodul in Verbindung mit dem Kommunikationsmodul und konfiguriert zum Einstellen einer virtuellen Spur mit willkürlicher Form und Länge durch eine grafische Bearbeitungsumgebung und zum Unterstützen der segmentalen Modifikation, des Löschens von Spuren und anderer Funktionen;
- ein Erfassungsmodul in Verbindung mit dem Kommunikationsmodul und konfiguriert zum Abrufen der Informationen zur virtuellen Spur aus dem Interaktionsmodul über das Kommunikationsmodul und zum Speichern von relevanten Daten,
- ein Orbitalschlüsselpunkt-Extraktionsmodul in Verbindung mit dem Erfassungsmodul, wobei das Erfassungsmodul konfiguriert ist, um die Informationen zur virtuellen Spur an das Orbitalschlüsselpunkt-Extraktionsmodul zu senden, und wobei das Orbitalschlüsselpunkt-Extraktionsmodul konfiguriert ist, um Schlüsselpunktinformationen der virtuellen Spur aus den Informationen zur virtuellen Spur gemäß einschränkenden Bedingungen wie einer Kurvensteigung und einer stückweisen Anpassung, um Schlüsselpunkte zu finden, bei denen die Ableitung erster Ordnung 0 ist, zu extrahieren;
- ein Sensordatenerfassungs- und -filterungsmodul, konfiguriert zum Sammeln von Daten eines Sensors auf der mobilen Vorrichtung und zum Entfernen von Rauschen auf den Daten über einen Filteralgorithmus;
- ein Odometer-Modul, konfiguriert zum Erhalten von Laufleistungsdaten der mobilen Vorrichtung; wobei das Sensordatenerfassungs- und -filterungsmodul und das Odometer-Modul zusammen einen Datenerfassungsteil bilden;
- ein Kartenmodul, konfiguriert zur Verwendung eines zugehörigen Algorithmus zur simultanen Lokalisierung und Kartierung, SLAM, um eine Umgebungskarte zu erstellen, wobei die Umgebungskarte für die globale Pfadplanung verwendet werden kann;
- ein autonomes Positionierungsmodul in Verbindung mit dem Kartenmodul und konfiguriert zum Konstruieren eines Speichermoduls durch Kombinieren der Umgebungskarte, wobei ein relevanter Übereinstimmungsalgorithmus verwendet wird, um die aktuellen Positionsinformationen und Lageinformationen der mobilen Vorrichtung zu erhalten, sodass die mobile Vorrichtung ihre Position und Lage in der Umgebungskarte in Echtzeit kennt;
wobei das Kartenmodul und das autonome Positionierungsmodul zusammen einen autonomen SLAM-Positionierungsteil bilden, und wobei der autonome SLAM-Positionierungsteil mit dem Datenerfassungsteil in Verbindung steht, um Sensordaten und Laufleistungsdaten zu empfangen;
- ein Orbitalschlüsselpunkt-Graphstrukturkonstruktionsmodul in Verbindung mit dem Extraktionsmodul und dem autonomen SLAM-Positionierungsteil und konfiguriert zum Nutzen von Schlüsselpunktinformationen, die von dem Orbitalschlüsselpunkt-Extraktionsmodul empfangen werden, und Karteninformationen, die von dem Sensordatenerfassungs- und -filterungsmodul über den autonomen SLAM-Positionierungsteil empfangen werden, um die Zugänglichkeit zwischen Schlüsselpunkten zu kombinieren, um Knoten- und Kanteninformationen der Graphstruktur zu konstruieren;
- ein Aufgabenplanungsverwaltungsmodul in Verbindung mit dem Kommunikationsmodul und konfiguriert zum Verwalten von Navigationsaufgaben, die von einem Benutzer ausgegeben werden, einschließlich des Einstellens einer Aufgabenreihenfolge, einer Aufgabenverteilung, einer Aufgabenausführungslogik, des Aufrufens eines Pfadplanungsdienstes und anderer Teile;
- ein Globalschlüsselpunkt-Pfadsuchmodul in Verbindung mit dem Aufgabenplanungsverwaltungsmodul und dem Orbitalschlüsselpunkt-Graphstrukturkonstruktionsmodul und konfiguriert zum: Suchen des optimalen Pfads entlang der virtuellen Spur vom Startpunkt zum Endpunkt gemäß einer vom Aufgabenverwaltungsplanungsmodul ausgegebenen Aufgabe und Informationen des autonomen Positionierungsmoduls, kombiniert mit einem heuristischen Suchalgorithmus, unter Verwendung der Orbitalschlüsselpunkt-Spurgraphenstruktur, die vom Orbitalschlüsselpunkt-Graphstrukturkonstruktionsmodul empfangen wird, und konfiguriert zum Anleiten der mobilen Vorrichtung, eine Routenaufgabe abzuschließen;
- ein Lokaltrajektorie-Plannungsmodul in Verbindung mit dem Globalschlüsselpunkt-Pfadsuchmodul und dem autonomen SLAM-Positionierungsteil und konfiguriert zum Generieren einer reibungslosen kollisionsfreien Steuerentscheidung unter Verwendung von Beobachtungsdaten, die fusioniert werden durch Multisensor, aktuelle virtuelle Spurknoteninformationen und autonome Positionierungsinformationen, und durch Kombinieren mit den aktuellen Geschwindigkeitsinformationen, sodass die mobile Vorrichtung die Routenaufgabe ohne Kollision abschließen kann;
- ein Bewegungssteuermodul in Verbindung mit dem Lokaltrajektorie-Plannungsmodul und konfiguriert zum Generieren von Bewegungssteuerentscheidungen unter Verwendung von kollisionsfreien Steuerentscheidungen, die durch das Lokaltrajektorie-Plannungsmodul generiert werden; und
- ein intelligentes Bewegungsmodul in Verbindung mit dem Steuervorrichtungsmodul und konfiguriert zum Empfangen der Anweisung des Bewegungssteuermoduls, um die kollisionsfreie Bewegung der mobilen Vorrichtung zu steuern.

2. Implementierungsverfahren für Trajektoriesteuerung in einem Trajektoriesteuersystem für eine mobile Vorrichtung, das die folgenden Schritte umfasst:
Schritt 1: Einstellen, Hinzufügen, Löschen und Bearbeiten einer virtuellen Spur in einem Interaktionsmodul und Senden von Informationen zur virtuellen Spur an einen Algorithmusverarbeitungsteil über ein Client-Kommunikationsmodul;
Schritt 2: Empfangen der vom Interaktionsmodul über das Client-Kommunikationsmodul gesendeten Informationen zur virtuellen Spur an einem Kommunikationsmodul des Algorithmusverarbeitungsteils;
Schritt 3: Empfangen der Informationen zur virtuellen Spur an einem Erfassungsmodul über das Kommunikationsmodul des Algorithmusverarbeitungsteils und Extrahieren von Schlüsselpunktinformationen der virtuellen Spur aus den Informationen zur virtuellen Spur gemäß einschränkenden Bedingungen wie einer Kurvensteigung und einer stückweisen Anpassung, um Schlüsselpunkte zu finden, bei denen die Ableitung erster Ordnung 0 ist, durch das Erfassungsmodul;
Schritt 4: Empfangen der Schlüsselpunktinformationen an einem Graphstrukturkonstruktionsmodul, Kombinieren der von einem Kartenmodul empfangenen Karteninformationen, der Schlüsselpunktinformationen zur virtuellen Spur und der Zugänglichkeit zwischen den Schlüsselpunkten, um Knoten- und Kanteninformationen einer Graphstruktur zu konstruieren;
Schritt 5: Empfangen, an einem Suchmodul, einer Navigationsaufgabe über das Kommunikationsmodul des Algorithmusverarbeitungsteils und von Positionierungsinformationen aus einem autonomen Positionierungsmodul, und Suchen eines Schlüsselpunktpfades entlang der virtuellen Spur vom Startpunkt zum Endpunkt gemäß einem Suchalgorithmus unter Verwendung der Graphstruktur der Schlüsselpunkte entlang der virtuellen Spur;
Schritt 6: Empfangen, an einem Trajektorieplanungsmodul, des in Schritt 5 generierten Schlüsselpunktpfads, Fusionsbeobachtungsinformationen und autonomen Positionierungsinformationen der mobilen Vorrichtung und Bewegungsgeschwindigkeits- und Modellinformationen der mobilen Vorrichtung, und Kombinieren des Schlüsselpunktpfads, der Fusionsbeobachtungsinformationen und der autonomen Positionierungsinformationen und der Bewegungsgeschwindigkeits- und Modellinformationen, um eine Steuerentscheidung zu generieren; und
Schritt 7: Empfangen, an einem Bewegungssteuermodul, der Steuerentscheidung von Schritt 6, Glätten der Geschwindigkeit gemäß der Steuerentscheidung und Ausgeben von Steueranweisungen an die mobile Vorrichtung, um die Bewegung der mobilen Vorrichtung zu steuern.

## Revendications

1. Système de commande de trajectoire pour dispositif mobile, comprenant :
- un module de communication pour fournir la transmission des informations cartographiques, des informations de piste virtuelle, des informations de positionnement et des informations de tâche pertinentes ;
- un module d'interaction en connexion avec le module de communication et configuré pour établir une piste virtuelle présentant une forme et une longueur arbitraires par l'intermédiaire d'un environnement d'édition graphique et pour prendre en charge une modification segmentaire, une suppression de pistes et d'autres fonctions ;
- un module d'acquisition en connexion avec le module de communication et configuré pour obtenir les informations de piste virtuelle à partir du module d'interaction via le module de communication et pour stocker des données pertinentes,
- un module d'extraction de point clé orbital en connexion avec le module d'acquisition, dans lequel le module d'acquisition est configuré pour envoyer les informations de piste virtuelle au module d'extraction de point clé orbital, et dans lequel le module d'extraction de point clé orbital est configuré pour extraire des informations de point clé de la piste virtuelle à partir des informations de piste virtuelle en fonction de conditions de limitation telles qu'une pente de courbe et un ajustement par morceaux pour trouver des points clés où la dérivée du premier ordre est 0 ;
- un module d'acquisition et de filtrage de données de capteur configuré pour collecter des données d'un capteur sur le dispositif mobile et pour éliminer le bruit des données via un algorithme de filtrage ;
- un module d'odomètre configuré pour obtenir des données de kilométrage du dispositif mobile ; dans lequel le module d'acquisition et de filtrage de données de capteur et le module d'odomètre forment ensemble une partie d'acquisition de données ;
- un module de carte configuré pour utiliser un algorithme relatif à une localisation et une cartographie simultanées, SLAM, pour construire une carte d'environnement, dans lequel la carte d'environnement peut être utilisée pour une planification de trajet global ;
- un module de positionnement autonome en connexion avec le module de carte et configuré pour construire un module de stockage en combinant la carte d'environnement, dans lequel un algorithme de mise en correspondance pertinent est utilisé pour obtenir des informations de position et des informations de posture de l'instant du dispositif mobile pour que le dispositif mobile connaisse sa position et sa posture dans la carte d'environnement en temps réel ;
dans lequel le module de carte et le module de positionnement autonome forment ensemble une partie de positionnement autonome SLAM, et dans lequel la partie de positionnement autonome SLAM est en connexion avec la partie d'acquisition de données pour recevoir des données de capteur et des données de kilométrage ;
- un module de construction de structure de graphe de point clé orbital en connexion avec le module d'extraction et avec la partie de positionnement autonome SLAM, et configuré pour utiliser des informations de point clé reçues depuis le module d'extraction de point clé orbital et des informations cartographiques reçues depuis le module d'acquisition et de filtrage de données de capteur via la partie positionnement autonome SLAM, pour combiner une accessibilité entre des points clés, pour construire des informations de sommets et d'arêtes de la structure de graphe ;
- un module de gestion de planification de tâches en connexion avec le module de communication et configuré pour gérer les tâches de navigation délivrées par un utilisateur, incluant l'établissement de la séquence des tâches, la distribution des tâches, la logique d'exécution des tâches, la demande d'un service de planification de trajet et d'autres parties ;
- un module de recherche de trajet de point clé global en connexion avec le module de gestion de planification de tâches et le module de construction de structure de graphe de point clé orbital et configuré pour : rechercher le trajet optimal le long de la piste virtuelle à partir d'un point de départ jusqu'à un point d'arrivée en fonction d'une tâche délivrée par le module de gestion de planification de tâches et d'informations du module de positionnement autonome, en combinaison avec un algorithme de recherche heuristique, en utilisant une structure de graphe de piste du point clé orbital reçue depuis le module de structure de graphe du point clé orbital, et configuré pour guider le dispositif mobile pour accomplir une tâche de croisière ;
- un module de planification de trajectoire locale en connexion avec le module de recherche de trajet clé global et la partie de positionnement autonome SLAM, et configuré pour générer une décision de commande homogène sans collision en utilisant des données d'observation fusionnées par de multiples capteurs, des informations de nœud de piste virtuelle de l'instant et des informations de positionnement autonome, et en les combinant avec les informations de vitesse de l'instant pour que le dispositif mobile puisse accomplir la tâche de croisière sans collision ;
- un module de commande de mouvement en connexion avec le module de planification de trajectoire locale et configuré pour générer des décisions de commande de mouvement en utilisant des décisions de commande sans collision générées par le module de planification de trajectoire locale ; et
- un module de mouvement intelligent en connexion avec le module de commande de mouvement et configuré pour recevoir l'instruction du module de commande de mouvement pour commander un mouvement sans collision du dispositif mobile.

2. Procédé d'implémentation pour commande de trajectoire dans un système de commande de trajectoire pour un dispositif mobile, comprenant les étapes suivantes :
Étape 1 : définir, ajouter, supprimer et éditer une piste virtuelle dans un module d'interaction et envoyer des informations de piste virtuelle à une partie de traitement par algorithme via un module de communication client ;
Étape 2 : recevoir les informations de piste virtuelle envoyées par le module d'interaction via le module de communication client à un module de communication de la partie de traitement par algorithme ;
Étape 3 : recevoir les informations de piste virtuelle de la piste virtuelle au niveau d'un module d'acquisition via le module de communication de la partie de traitement par algorithme, et extraire, par le module d'acquisition, des informations de point clé de la piste virtuelle à partir des informations de piste virtuelle en fonction de conditions de limitation telles qu'une pente de courbe et un ajustement par morceaux pour trouver des points clés où la dérivée du premier ordre est 0 ;
Étape 4 : recevoir les informations de points clés au niveau d'un module de construction de structure de graphe, combiner des informations cartographiques reçues depuis un module de carte, des informations de points clés de la piste virtuelle, et une accessibilité entre des points clés pour construire des informations de sommets et d'arêtes d'une structure de graphe ;
Étape 5 : recevoir, au niveau d'un module de recherche, une tâche de navigation via le module de communication de la partie de traitement par algorithme et des informations de positionnement depuis un module de positionnement autonome, et rechercher, en fonction d'un algorithme de recherche, un trajet de points clés le long de la piste virtuelle à partir d'un point de départ jusqu'à un point d'arrivée en utilisant la structure de graphe des points clés le long de la piste virtuelle ;
Étape 6 : recevoir, au niveau d'un module de planification de trajectoire, le trajet de points clés généré dans l'étape 5, des informations d'observation de fusion et des informations de positionnement autonome du dispositif mobile, et des informations de modèle et de vitesse de mouvement du dispositif mobile, et combiner le trajet de points clés, les informations d'observation de fusion et des informations de positionnement autonome et les informations de modèle et de vitesse de mouvement pour générer une décision de commande ; et
Étape 7 : recevoir, au niveau d'un module de commande de mouvement, la décision de commande de l'étape 6, lisser la vitesse en fonction de la décision de commande, et délivrer des instructions de commande au dispositif mobile pour commander le mouvement du dispositif mobile.
